# EUROPEAN PATENT SPECIFICATION

(11) **EP 4 597 058 B1**
(45) Date of publication and mention of the grant of the patent: **03.06.2026**
(21) Application number: 25153720.5
(22) Date of filing: 24.01.2025
(51) Int. Cl.: G01K 7/42, G01R 31/42, H02K 9/19, H02K 11/20, H02K 11/25, H02M 1/32, H02M 7/00, H02M 7/5387, B62D 5/04, G05B 13/04, H02K 11/04, H02P 29/68

(54) **POWER SUPPLY DEVICE AND TEMPERATURE MEASURING METHOD THEREOF**
STROMVERSORGUNGSVORRICHTUNG UND TEMPERATURMESSVERFAHREN DAFÜR
DISPOSITIF D'ALIMENTATION ÉLECTRIQUE ET PROCÉDÉ DE MESURE DE TEMPÉRATURE ASSOCIÉ

(30) Priority: 31.01.2024 US 202463627094 P
(43) Date of publication of application: 06.08.2025
(73) Proprietor: Delta Electronics, Inc., Taoyuan City 333 (TW)
(72) Inventor: LIU, Hung-Hsiao, 333 Taoyuan City (TW); WANG, Yu-Lin, 333 Taoyuan City (TW); SU, Wei-Te, 333 Taoyuan City (TW)
(74) Representative: Riccardi, Elisa

(56) References cited:
- US-A1- 2023 014 410

## Description

### BACKGROUND

### Field of Invention

This disclosure relates to a power supply device, and a temperature measuring method, and in particular to the power supply device, and the temperature measuring method for estimating a transient temperature.

### Description of Related Art

Thermal management systems usually rely on basic thermal models and require manual calibration. Under varying operating conditions, this approach can lead to inefficiencies and possible failures. A temperature measuring device can be configured to measure an operating temperature of a circuit device. However, the temperature measuring device is able to measure a steady-state temperature of the circuit device, such as temperature changes every 10 seconds during the continuous operation of the circuit device. The steady-state temperature measurement can only represent an overall operating temperature of the circuit device, and cannot detect a transient temperature of a core circuit of the circuit device at a specific moment (for example, measuring a channel interface temperature of a power inverter switch at the moment of switching). An inverter and estimation of an internal temperature of a semiconductor switch are disclosed in US 2023/014410 A1.

Since temperature measuring devices cannot measure or calculate the transient temperature of a specific component inside a circuit in real time, this may make temperature monitoring difficult.

### SUMMARY

The present disclosure provides a power supply device. The power supply device includes an operating circuit, a circuit measuring device, and a computing circuit. The circuit measuring device is configured to continuously sense the operating circuit to obtain a data that varies over time. The computing circuit is coupled to the circuit measuring device. The computing circuit is configured to receive the data about the operating circuit, substitute or provide the data into a deflection model to obtain a simulated temperature of the operating circuit, and determine whether the operating circuit is abnormal according to the simulated temperature. The deflection model is established through a deflection operation according to a plurality of physical parameters of the operating circuit.

The present disclosure provides a temperature measuring method for a power supply device. The power supply device includes an operating circuit, a circuit measuring device and a computing circuit. The temperature measuring method includes continuously sensing the operating circuit to obtain a data that varies over time, substituting or providing the data into a deflection model to obtain a simulated temperature of the operating circuit, and determining whether the operating circuit is abnormal according to the simulated temperature. The deflection model is established through a deflection operation according to a plurality of physical parameters of the operating circuit.

The deflection model is established by measuring a plurality of first physical parameters of the operating circuit; performing the deflection operation to simplify the first physical parameters into a plurality of second physical parameters, wherein an amount of the second physical parameters is less than an amount of the first physical parameters; and establishing the deflection model according to the first physical parameters and the second physical parameters. The first physical parameters at least comprise a coolant flow of the operating circuit, a coolant density of the operating circuit, a coolant isobaric specific heat of the operating circuit, a coolant thermal conductivity of the operating circuit, and a coolant viscosity coefficient of the operating circuit. The second physical parameters comprise a voltage variable, a current variable, and a coolant flow rate of the operating circuit.

According to the embodiments of the present disclosure, the power supply device of the present disclosure only needs to measure the voltage variable, current variable and coolant flow rate to calculate the simulated temperature of the operating circuit through the deflection model. Therefore, the power supply device can achieve the beneficial technical effect of saving computing performance. It can also be understood that, through the deflection model, the computing circuit in the power supply device does not need to have strong computing performance, so the production cost of the power supply device can be reduced.

### BRIEF DESCRIPTION OF THE DRAWINGS

Fig.1 is a schematic diagram of a power supply device according to an embodiment of the present disclosure.
Fig. 2 is a schematic diagram of internal components of the operating circuit according to an embodiment of Fig.1.
Fig. 3 is a first structure function curve diagram according to an embodiment of the present disclosure.
Fig. 4 is a curve diagram of the first structure function and the second structure function according to an embodiment of the present disclosure.
Fig. 5 is a flow chart of a temperature measuring method according to an embodiment of the present disclosure.
Fig. 6 is a schematic diagram of an operating module according to an embodiment of the present disclosure.

### DETAILED DESCRIPTION

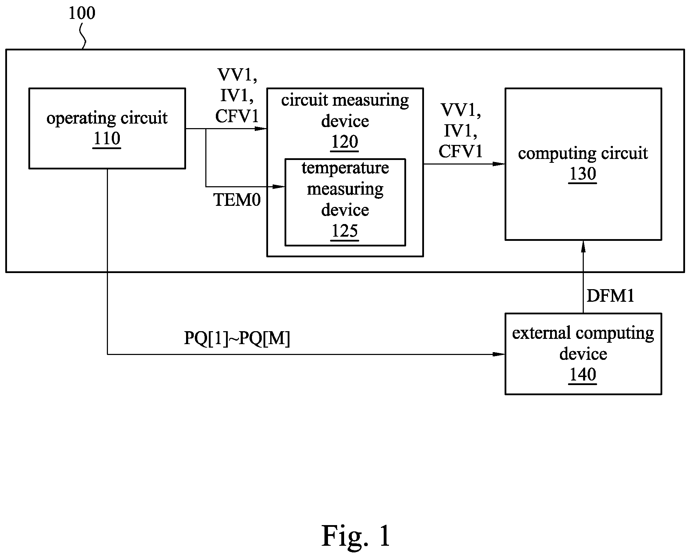

Reference is made to Fig.1. Fig.1 is a schematic diagram of a power supply device 100 according to an embodiment of the present disclosure. In the embodiment of Fig. 1, the power supply device 100 includes an operating circuit 110, a circuit measuring device 120 and a computing circuit 130. The circuit measuring device 120 includes a temperature measuring device 125. Further, the power supply device 100 is coupled to an external computing device 140.

In this embodiment, the power supply device 100 can be used as a power supply system for an electric vehicle. However, the present disclosure is not limited thereto. The power supply device 100 can also be used in a renewable energy system (e.g., solar energy or wind energy) or a power supply device according to direct current (e.g., a storage battery) feeding power to an alternating current grid. The operating circuit 110 may be configured to convert a DC power input (e.g., a storage battery, a solar panel, or a wind turbine) into a specific AC power output. The operating circuit 110 may include components such as a coupled inductor, an inverter switch, and a water-cooled motor. The operating circuit 110 may achieve an AC power output through the above components.

In this embodiment, a measuring terminal of the circuit measuring device 120 may be disposed in the operating circuit 110. The circuit measuring device 120 may be configured to measure the voltage and current of the internal components of the operating circuit 110. In addition, the circuit measuring device 120 may also measure the coolant of a water-cooled motor of the operating circuit 110. The circuit measuring device 120 is configured to continuously sense the operating circuit 110 to obtain data that varies over time. The data may come from a fixed detection point on the operating circuit 110. The data may also come from multiple detection points on the operating circuit 110. In addition, the data includes a voltage variable VV1, a current variable IV1, and a coolant flow rate CFV1. The present disclosure is not limited to the above. Outside the scope of the claimed invention, the circuit measuring device 120 may also continuously sense the operating circuit 110 to obtain different data such as the ambient temperature and the coolant temperature that varies over time.

A measuring terminal of the temperature measuring device 125 of the circuit measuring device 120 may also be disposed in the operating circuit 110 to measure the initial temperature TEMO of the operating circuit 110 at the initial timepoint of operation (also referred as the "initial state") of the power supply device 100.

The computing circuit 130 is coupled to the circuit measuring device 120 and the external computing device 140. The computing circuit 130 receives the voltage variable VV1, the current variable IV1, and the coolant flow rate CFV1 from the circuit measuring device 120, and the computing circuit 130 obtains a deflection model DFM1, for example from the external computing device 140. The deflection model DFM1 of the present disclosure takes a reduced order matrix model as an example.

The computing circuit 130 may be a single-chip system, an embedded system, or a system on a chip (SoC). The computing circuit 130 is configured to obtain a simulated temperature of the operating circuit 110 during operation. Since the computing circuit 130 may be a single-chip system, the capacity and computing power of the computing circuit 130 are limited, and the computing circuit 130 may not be able to perform complex computing operations. Therefore, the computing circuit 130 may need to obtain the simulated temperature through the deflection model DFM1. It is worth mentioning that the simulated temperature may be the maximum temperature value in the operating circuit 110.

The computing circuit 130 substitutes the voltage variable VV1, the current variable IV1, and the coolant flow rate CFV1 into the deflection model DFM1, to obtain the simulated temperature of the operating circuit 110 during operation.

The computing circuit 130 determines whether the operating circuit 110 is abnormal according to the simulated temperature. Furthermore, the computing circuit 130 may set a threshold value according to the voltage variable VV1, the current variable IV1, the coolant flow rate CFV1, and the deflection model DFM1, or the user may preset a specific value as the threshold value. When the simulated temperature calculated by the computing circuit 130 is greater than the threshold value, the computing circuit 130 may determine that the operating circuit 110 is abnormal. In this case, the internal temperature of the operating circuit 110 may be too high and the operating circuit 110 may be malfunctioning. The computing circuit 130 may quickly cut off the power supply by shutting down the operating circuit 110 to protect the power supply device 100 from damage due to overload or malfunction.

In some other embodiments, the computing circuit 130 may further substitute the initial temperature TEMO measured by the temperature measuring device 125 into the deflection model DFM1. The computing circuit 130 may calculate a transient power of the operating circuit 110 at a certain time point according to the voltage variable VV1, the current variable IV1, and the coolant flow rate CFV1. After the transient power is obtained, the computing circuit 130 may calculate the simulated temperature according to the initial temperature TEMO and the transient power.

In the above embodiments, the deflection model DFM1 is established by the external computing device 140 through a deflection operation. The external computing device 140 can measure physical parameters PQ[1]-PQ[M] from the operating circuit 110, and perform the deflection operation to the physical parameters PQ[1]~PQ[M] to establish a deflection model DFM1.

Through the deflection operation, a complex three-dimensional model can be simplified into a more manageable form to improve simulation efficiency without losing too much accuracy. First physical parameters may be simplified into a thermal convection coefficient. The thermal convection coefficient may be obtained through second physical parameters, and the amount of the second physical parameters is less than the amount of the first physical parameters. In other words, through the deflection operation, the first physical parameters (e.g., the three-dimensional model) can be simplified into the second physical parameters (in numerical form). Corresponding to the above embodiment, the first physical parameters in this paragraph may be the physical parameters PQ[1]~PQ[M] measured by the external computing device 140. The external computing device 140 may simplify the first physical parameters (i.e., the physical parameters PQ[1]~PQ[M]) into the second physical parameters through the deflection operation. And through the first physical parameters and the second physical parameters, the deflection model DFM1 may be established.

In an embodiment, the first physical parameters may be the physical parameters PQ[1]-PQ[M] measured by the external computing device 140, and the first physical parameters may be inputted into the power supply device 100 as a three-dimensional model. The physical parameters PQ[1]-PQ[M] at least include the coolant flow, a coolant density, a coolant isobaric specific heat, a coolant thermal conductivity, a coolant viscosity coefficient of the operating circuit 110, e.g. of the chilled water motor in the operating circuit 110, and may include the ambient temperature when the operating circuit 110 is operating. The second physical parameters may be simple numerical values (outside the scope of the claimed invention), or may be the voltage variable VV1, the current variable IV1, and the coolant flow rate CFV1 of the operating circuit 110.

In some embodiments, the deflection model DFM1 may be implemented by multiple operation logic gates. In some other embodiments, the deflection model DFM1 may be represented in the form of mechanical code.

It is worth mentioning that the external computing device 140 and the power supply device 100 are different devices. The external computing device 140 may be a computer device installed in a laboratory. In the laboratory, a use environment equivalent to the power supply device 100 can be constructed, and the ambient temperature of the use environment and the physical parameters PQ[1]~PQ[M] of the operating circuit 110 can be adjusted as required. The external computing device 140 can measure the operating circuit 110 under different ambient temperatures. The external computing device 140 can further calculate the corresponding relationship among the ambient temperature, the physical parameters PQ[1]~PQ[M], the voltage variable VV1, the current variable IV1, and the coolant flow rate CFV1 of the operating circuit 110, and establish the deflection model DFM1.

In summary, through the deflection model DFM1, the power supply device 100 only needs to measure the voltage variable VV1, the current variable IV1 and the coolant flow rate CFV1, so that the computing circuit 130 can calculate the simulated temperature of the operating circuit 110 without measuring and calculating each of the physical parameters PQ[1]~PQ[M]. Therefore, the power supply device 100 can achieve the beneficial technical effect of saving computing performance. It can also be understood that, through the deflection model DFM1, the computing circuit 130 in the power supply device 100 does not need to have strong computing performance, so the production cost of the power supply device 100 can be reduced.

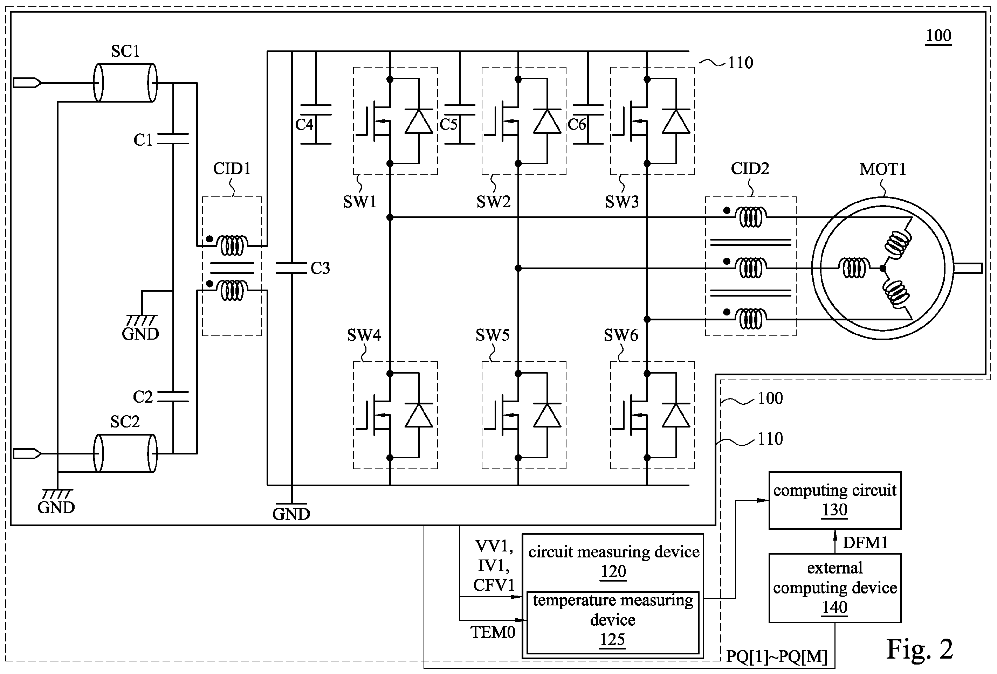

Reference is further made to Fig. 2. Fig. 2 is a schematic diagram of internal components of the operating circuit 110 according to an embodiment of Fig.1. In this embodiment, the operating circuit 110 may include cables SC1, SC2, coupled inductors CID1, CID2, capacitors C1-C6, inverter switches SW1-SW6, and a motor MOT1.

The cables SC1 and SC2 may receive an input voltage and be coupled to a ground terminal GND. The cable SC1 may also be coupled to a first terminal of a capacitor C1. A second terminal of capacitor C1 is coupled to the ground terminal GND and a first terminal of capacitor C2. The cable SC2 may also be coupled to a second terminal of capacitor C2. In one embodiment, the cables SC1 and SC2 may be shielded cables with surfaces coated with insulating materials.

A first input terminal of the coupled inductor CID1 is coupled to the first terminal of capacitor C1. A first output terminal of the coupled inductor CID1 is coupled to a first terminal of capacitor C3 and a first terminal of capacitor C4. A second input terminal of the coupled inductor CID1 is coupled to the second terminal of the capacitor C2. A second output terminal of the coupled inductor CID1 is coupled to a second terminal of the capacitor C3 and the ground terminal GND. A second terminal of the capacitor C4 is coupled to ground terminal GND.

A first terminal of the inverter switch SW1 is coupled to the capacitor C4, the capacitor C5, a first terminal of the inverter switch SW2, the capacitor C6, and a first terminal of the inverter switch SW3. A second terminal of the inverter switch SW1 is coupled to a first terminal of the inverter switch SW4. A second terminal of the inverter switch SW2 is coupled to a first terminal of the inverter switch SW5. A second terminal of the inverter switch SW3 is coupled to a first terminal of the inverter switch SW6. A second terminal of the inverter switch SW4, the second terminal of the inverter switch SW5, and a second terminal of the inverter switch SW6 are all coupled to the ground terminal GND.

The inverter switch SW1~SW6 may be insulated gate bipolar transistor (IGBT) switches or metal oxide semiconductor field effect transistor (MOSFET). The computing circuit 130 may generate gate signals to drive the inverter switches SW1~SW6, thereby controlling the operation of the inverter switches SW1~SW6. The inverter switches SW1~SW6 may generate three-phase AC power by switching their switch states according to the gate signals. The inverter switches SW1~SW6 are controlled by precise switching actions to generate the waveforms of the required frequency and voltage. The inverter switches SW1~SW6 can form a three-phase system, and the switches of each phase can control the voltage of their own phase, thereby forming a balanced three-phase alternating current. By adjusting the switching speed of the inverter switches SW1~SWB6, the output frequency of the inverter switches can be adjusted to control a motor speed (the "motor speed" can be the rotation speed of motor MOT1).

The inverter switches SW1~SW6 are coupled to an input terminal of the coupled inductor CID2. The three-phase input terminal of motor MOT1 is coupled to an output terminal of coupled inductor CID2.

In this embodiment, the simulated temperature calculated by the computing circuit 130 may be an ideal operating temperature of the inverter switch. When the ideal operating temperature of the inverter switch is greater than the threshold value mentioned above, it may mean that the inverter switches SW1~SW6 have been worn out or malfunctioning. When the inverter switches SW1-SW6 are determined to be malfunctioning, the power supply device 100 may prompt maintenance personnel to replace them. In some embodiments, the power supply device 100 may identify service life of a specific inverter switch among the inverter switches SW1-SW6 and issue a targeted replacement prompt.

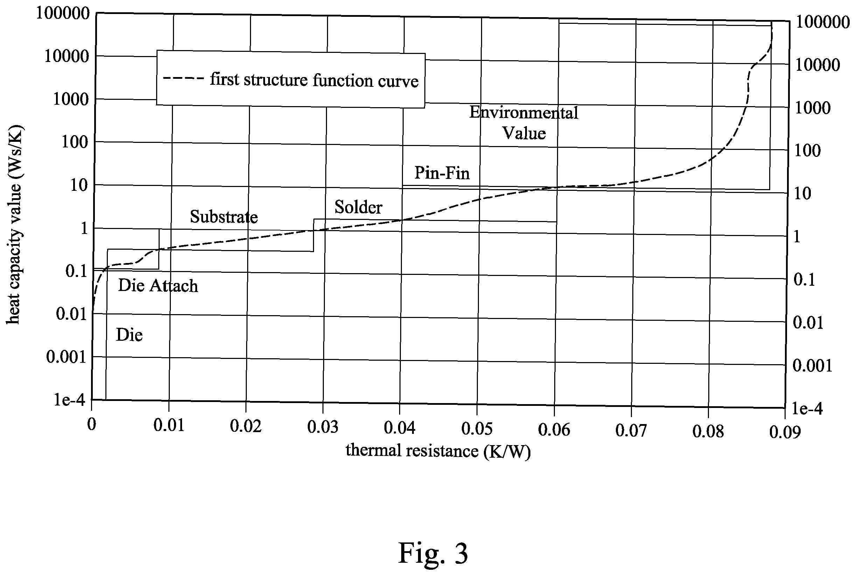

Reference is further made to Fig. 3. Fig. 3 is a first structure function curve diagram according to an embodiment of the present disclosure. The first structure function curve is obtained by measuring thermal resistance and heat capacity value of the die, substrate, solder, pin-fin, and environmental value used by the power supply device 100 by the external computing device 140, and the curve can be configured to express the first structure function generated by the deflection model DFM1 according to the physical parameters PQ[1]~PQ[M] of the operating circuit 110 in Fig. 1. It is worth mentioning that the first structure function can be a heat flow structure function.

By measuring the physical parameters PQ[1]~PQ[M] of the operating circuit 110, the corresponding relationship between the thermal resistance and the heat capacity value of the power supply device 100 can be obtained.

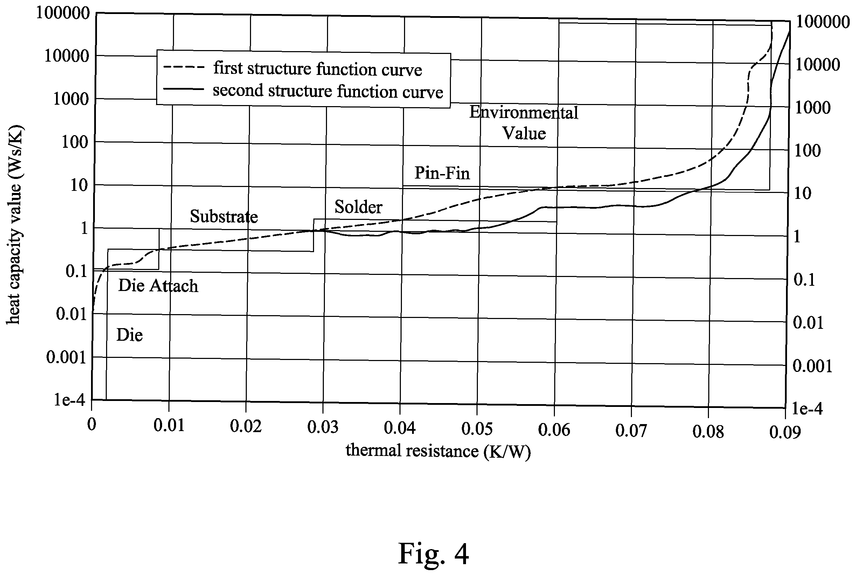

Reference is further made to Fig. 4. Fig. 4 is a curve diagram of the first structure function and the second structure function according to an embodiment of the present disclosure.

The first structure function curve in Fig. 4 is the same as the first structure function curve in Fig. 3. The difference between Fig. 3 and Fig. 4 is that Fig. 4 includes a second structure function curve. Like the first structure function, the second structure function can also be a heat flow structure function. The first structure function curve and the second structure function curve may partially overlap. As shown in Figure 4, in the "Die", "Die Attach" and "Substrate" regions, the first structure function curve and the second structure function curve overlap with each other, and the bifurcation point between the first structure function curve and the second structure function curve is located in the "Die Attach" region.

In the embodiment of Fig. 4, the external computing device 140 can read the measured values, such as the voltage variable VV1, the current variable IV1 or the coolant flow rate CFV1, through the computing circuit 130. The external computing device 140 can also read the simulated temperature obtained through the deflection model DFM1, and the external computing device 140 can obtain the real-time temperature change of the component according to the architecture presented by the first structure function. By using the computing circuit 130, a specific temperature change is obtained multiple times within a specific time (i.e., a time point corresponding to the first structure function), the thermal resistance on the structure function is derived, and then the thermal resistance is connected to let the second structure function curve be obtained. The tested object may have structural changes after operating for a period of time, resulting in the second structure function curve that is different from the first structure function curve. Therefore, it can be defined that another second structure function curve different from the first structure function curve to represent the state of the tested object when it is abnormal.

Through the visual presentation in Fig. 4, the user can clearly know whether there is a difference between an actual state of the operating circuit 110 and an ideal state. Any point on the second structure function curve can be compared with the corresponding point on the first structure function curve (for example: thermal resistance of 0.04K/W, 0.05K/W, etc.), and determine whether the tested object is in an abnormal state, for example: whether the die attach corresponding to the tested object is abnormal. In addition, any line segment on the second structure function curve can be compared with a corresponding line segment on the first structure function curve (for example: the line segment with thermal resistance of 0.04K/W~0.05K/W, which is the line segment corresponding to die attach) to determine whether the die attach of the tested object is in an abnormal state.

The power supply device of the present disclosure is to measure the structure function generated by temperature changes in a short period of time, and thus the power supply device can measure the transient response or transient change of the tested object with temperature changes. Therefore, the temperature estimated according to the present invention is more accurate than the well-known technology. Since the structure function of the power supply device of the present disclosure is obtained through transient changes of a multi-layer structure, when the tested object is abnormal, the method of the present disclosure can be used to identify in which layer of the structure of the tested object is abnormal. For example, the layer of die attach is abnormal. The present disclosure can improve the misjudgment of the well-known method. In some situations, the surface temperature of a tested object may be normal, but the temperature of its inner structure is too high. In those situations, the power supply device of the present disclosure is able to improve the accuracy of measurement and ensure the safety of the tested object.

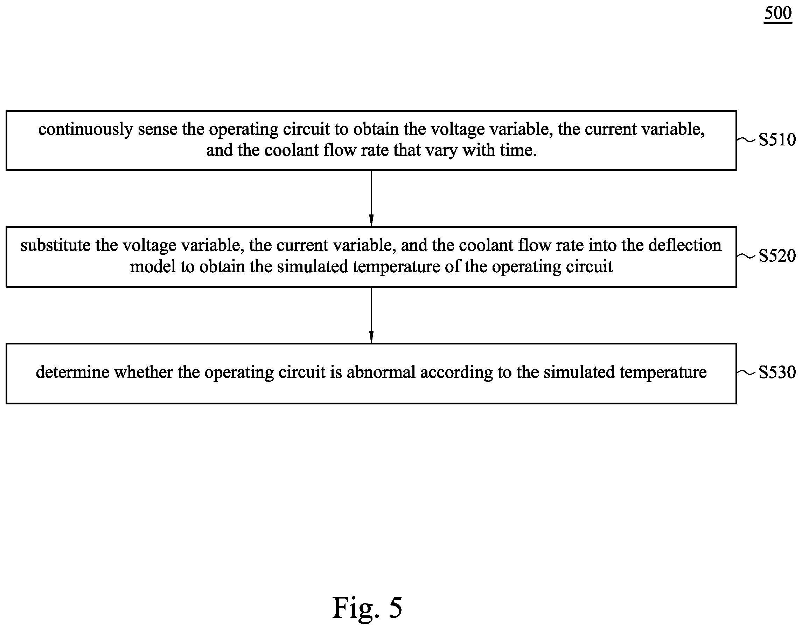

Reference is further made to Fig. 5. Fig. 5 is a flow chart of a temperature measuring method according to an embodiment of the present disclosure. The temperature measuring method 500 is configured to indicate the operating method of the power supply device 100.

In step S510, the circuit measuring device 120 of the power supply device 100 continuously senses the operating circuit 110 to obtain the voltage variable VV1, the current variable IV1, and the coolant flow rate CFV1 that vary with time.

In step S520, the computing circuit 130 of the power supply device 100 substitutes or provides the voltage variable VV1, the current variable IV1, and the coolant flow rate CFV1 into the deflection model DFM1 to obtain the simulated temperature of the operating circuit 110. In this embodiment, the deflection model DFM1 is established according to the physical parameters PQ[1]-PQ[M] of the operating circuit 110 through a deflection operation.

In step S530, the computing circuit 130 may determine whether the operating circuit 110 is abnormal according to the simulated temperature.

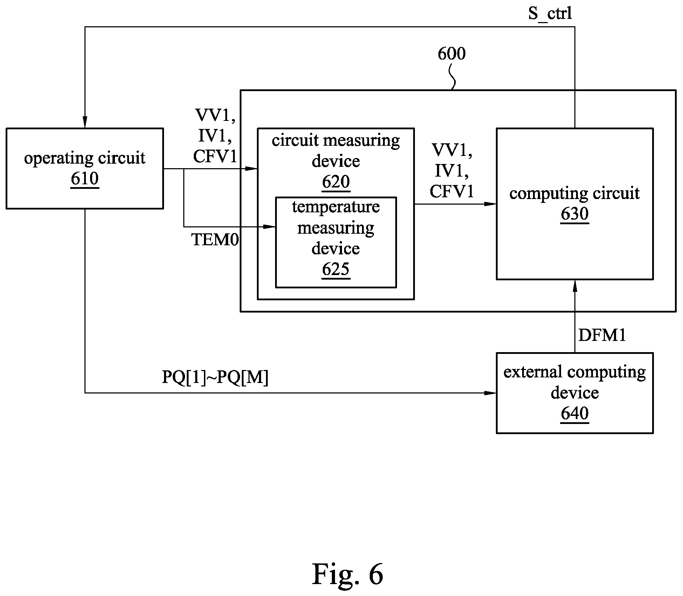

Reference is made to Figs. 1 and 6. Fig. 6 is a schematic diagram of an operating module 600 according to an embodiment of the present disclosure, which may be part of the claimed power supply device. The operating module 600 of Fig. 6 includes a circuit measuring device 620 and a computing circuit 630. The circuit measuring device 620 includes a temperature measuring device 625. The circuit measuring device 620 and the computing circuit 630 of Fig. 6 may correspond to the circuit measuring device 120 and the computing circuit 130 of Fig. 1. In Fig. 6, the operating module 600 can be connected to an operating circuit 610 and an external computing device 640. The operating circuit 610 and the external computing device 640 of Fig. 6 may correspond to the operating circuit 110 and the external computing device 140 of Fig. 1.

In the embodiment of Fig. 6, the operation details of the circuit measuring device 620 and the computing circuit 630 may also correspond to the circuit measuring device 120 and the computing circuit 130 of Fig. 1. A measuring terminal of the circuit measuring device 620 can be disposed in the operating circuit 610 to measure voltage and current of internal components of the operating circuit 610 and obtain a data that varies with time, such as the voltage variable VV1, the current variable IV1 and the coolant flow rate CFV1. The temperature measuring device 625 in the circuit measuring device 620 may measure and receive the initial temperature TEMO about the operating circuit 610.

The computing circuit 630 may receive the voltage variable VV1, the current variable IV1, and the coolant flow rate CFV1 from the circuit measuring device 620, and the computing circuit 630 may obtain the deflection model DFM1 from the external computing device 640. The details of the deflection model DFM1 can be found in the embodiment of Fig. 1 mentioned above.

The computing circuit 630 may substitute the voltage variable VV1, current variable IV1 and coolant flow rate CFV1 into the deflection model DFM1 to calculate a simulated temperature of the operating circuit 610 during operation. The computing circuit 630 can determine whether the operating circuit 610 is abnormal according to the simulated temperature, and the computing circuit 630 can generate a control signal S_ctrl according to the determination result.

The computing circuit 630 may transmit the control signal S_ctrl to the operating circuit 610 to control the operating circuit 610. In this embodiment, the computing circuit 630 can set a threshold value according to the voltage variable VV1, the current variable IV1, the coolant flow rate CFV1 and the deflection model DFM1, or the user can preset a specific value as the threshold value. When the simulated temperature calculated by the computing circuit 630 is greater than the threshold value, the computing circuit 630 may determine that the operating circuit 610 is abnormal. In this case, the computing circuit 630 may shut down the operating circuit 610 by the control signal S_ctrl, so that the operating circuit 610 is quickly powered off to protect the operating circuit 610 from damage due to overload or malfunction.

It is worth mentioning that the operating module 600 can be adapted to a variety of different types of operating circuits. The present disclosure does not limit the specific circuit type of the operating circuit 610. The operating circuit 610 only needs to allow the operating module 600 and the external computing device 640 to measure the required data.

In summary, through the deflection model DFM1, the power supply device 100 only needs to measure the voltage variable VV1, the current variable IV1 and the coolant flow rate CFV1, so that the computing circuit 130 can calculate the simulated temperature of the operating circuit 110 without measuring and calculating each of the physical parameters PQ[1]~PQ[M]. Therefore, the power supply device can achieve the beneficial technical effect of saving computing performance. It can also be understood that, through the deflection model DFM1, the computing circuit 130 in the power supply device 100 does not need to have strong computing performance, so the production cost of the power supply device 100 can be reduced. When the power supply device of the present disclosure includes a metal tested object with a multi-layer structure, the structural function curve or the curve of transient thermal resistance varying with time of the tested object can be quickly calculated, so the work efficiency can be improved.

## Claims

1. A power supply device (100), comprising:
an operating circuit (110);
a circuit measuring device (120), configured to continuously sense the operating circuit to obtain a data (VV1, IV1, CFV1) that varies over time; and
a computing circuit (130), coupled to the circuit measuring device (120), configured to:
receive the data about the operating circuit (110);
provide the data into a deflection model (DFM1) to obtain a simulated temperature of the operating circuit (110), wherein the deflection model (DFM1) is established through a deflection operation according to a plurality of physical parameters (PQ[1]~PQ[M]) of the operating circuit (110); and
determine whether the operating circuit (110) is abnormal according to the simulated temperature,
wherein the deflection model (DFM1) is established by following steps:
measuring a plurality of first physical parameters (PQ[1]~PQ[M]) of the operating circuit (110);
performing the deflection operation to simplify the first physical parameters into a plurality of second physical parameters, wherein an amount of the second physical parameters is less than an amount of the first physical parameters; and
establishing the deflection model (DFM1) according to the first physical parameters and the second physical parameters,
wherein the first physical parameters at least comprise a coolant flow of the operating circuit (110), a coolant density of the operating circuit (110), a coolant isobaric specific heat of the operating circuit (110), a coolant thermal conductivity of the operating circuit (110), and a coolant viscosity coefficient of the operating circuit (110), and
wherein the second physical parameters comprise a voltage variable (VV1), a current variable (IV1), and a coolant flow rate (CFV1) of the operating circuit (110).

2. The power supply device (100) of claim 1, wherein the deflection model (DFM1) is a matrix model, and the deflection model (DFM1) is configured to generate a first structure function of the operating circuit (110) according to the first physical parameters.

3. The power supply device (100) of claim 1, wherein,
the circuit measuring device (120) comprises a temperature measuring device (125), the temperature measuring device (125) is configured to measure an initial temperature (TEMO) in an initial state of the power supply device (100); and
the computing circuit (130) is further configured to obtain the simulated temperature through the initial temperature (TEMO), the voltage variable (VV1), the current variable (IV1) and the coolant flow rate (CFV1).

4. A temperature measuring method (500) for a power supply device (100), the power supply device (100) comprising an operating circuit (110), a circuit measuring device (120) and a computing circuit (130), the temperature measuring method (100) comprising:
continuously sensing the operating circuit (110) to obtain a data (VV1, IV1, CFV1) that varies over time;
providing the data into a deflection model (DFM1) to obtain a simulated temperature of the operating circuit (110), wherein the deflection model (DFM1) is established through a deflection operation according to a plurality of physical parameters (PQ[1]~PQ[M]) of the operating circuit (110); and
determining whether the operating circuit (110) is abnormal according to the simulated temperature,
wherein the deflection model is established by following steps:
measuring a plurality of first physical parameters (PQ[1]~PQ[M]) of the operating circuit (110);
performing the deflection operation to simplify the first physical parameters into a plurality of second physical parameters, wherein an amount of the second physical parameters is less than an amount of the first physical parameters; and
establishing the deflection model (DFM1) according to the first physical parameters and the second physical parameters,
wherein the first physical parameters at least comprise a coolant flow of the operating circuit (110), a coolant density of the operating circuit (110), a coolant isobaric specific heat of the operating circuit (110), a coolant thermal conductivity of the operating circuit (110), and a coolant viscosity coefficient of the operating circuit (110), and
wherein the second physical parameters comprise a voltage variable (VV1), a current variable (IV1), and a coolant flow rate (CFV1) of the operating circuit (110).

5. The temperature measuring method (500) of claim 4, wherein the deflection model (DFM1) is a matrix model, and the deflection model is configured to generate a first structure function of the operating circuit (110) according to the first physical parameters.

6. The temperature measuring method (500) of claim 4, wherein the circuit measuring device (120) comprises a temperature measuring device (125), and the temperature measuring method further comprises:
measuring an initial temperature (TEMO) in an initial state of the power supply device by the temperature measuring device (125); and
obtaining the simulated temperature through the initial temperature (TEMO), the voltage variable (VV1), the current variable (IV1) and the coolant flow rate (CFV1).

## Patentansprüche

1. Stromversorgungsvorrichtung (100), die Folgendes umfasst:
eine Betriebsschaltung (110);
eine Schaltungsmessvorrichtung (120), die so konfiguriert ist, dass sie die Betriebsschaltung kontinuierlich abtastet, um Daten (VV1, IV1, CFV1) zu erhalten, die sich über die Zeit verändern; und
eine Rechenschaltung (130), die mit der Schaltungsmessvorrichtung (120) gekoppelt ist und so konfiguriert ist, dass sie:
die Daten über den Betriebskreislauf (110) empfangen;
Bereitstellen der Daten in einem Ablenkungsmodell (DFM1), um eine simulierte Temperatur des Betriebsschaltkreises (110) zu erhalten, wobei das Ablenkungsmodell (DFM1) durch einen Ablenkungsvorgang gemäß einer Vielzahl von physikalischen Parametern (PQ[1]~PQ[M]) des Betriebsschaltkreises (110) erstellt wird; und
festzustellen, ob der Betriebskreislauf (110) in Abhängigkeit von der simulierten Temperatur anormal ist,
wobei das Durchbiegungsmodell (DFM1) durch die folgenden Schritte erstellt wird:
Messung einer Vielzahl von ersten physikalischen Parametern (PQ[1]~PQ[M]) der Betriebsschaltung (110);
Durchführen der Ablenkungsoperation, um die ersten physikalischen Parameter in eine Vielzahl von zweiten physikalischen Parametern zu vereinfachen, wobei ein Betrag der zweiten physikalischen Parameter kleiner als ein Betrag der ersten physikalischen Parameter ist; und
Erstellung des Durchbiegungsmodells (DFM1) in Abhängigkeit von den ersten physikalischen Parametern und den zweiten physikalischen Parametern,
wobei die ersten physikalischen Parameter zumindest einen Kühlmittelfluss des Betriebskreislaufs (110), eine Kühlmitteldichte des Betriebskreislaufs (110), eine isobare spezifische Wärme des Betriebskreislaufs (110), eine Kühlmittelwärmeleitfähigkeit des Betriebskreislaufs (110) und einen Kühlmittelviskositätskoeffizienten des Betriebskreislaufs (110) umfassen, und
wobei die zweiten physikalischen Parameter eine Spannungsvariable (VV1), eine Stromvariable (IV1) und eine Kühlmitteldurchflussrate (CFV1) des Betriebskreislaufs (110) umfassen.

2. Stromversorgungsvorrichtung (100) nach Anspruch 1, wobei das Ablenkungsmodell (DFM1) ein Matrixmodell ist und das Ablenkungsmodell (DFM1) so konfiguriert ist, dass es eine erste Strukturfunktion der Betriebsschaltung (110) entsprechend den ersten physikalischen Parametern erzeugt.

3. Stromversorgungsvorrichtung (100) nach Anspruch 1, wobei,
die Schaltungsmessvorrichtung (120) eine Temperaturmessvorrichtung (125) umfasst,
wobei die Temperaturmessvorrichtung (125) konfiguriert ist, um eine Anfangstemperatur (TEMO) in einem Anfangszustand der Stromversorgungsvorrichtung (100) zu messen; und
die Rechenschaltung (130) ferner so konfiguriert ist, dass sie die simulierte Temperatur durch die Anfangstemperatur (TEM0), die Spannungsvariable (VV1), die Stromvariable (IV1) und die Kühlmitteldurchflussmenge (CFV1) erhält.

4. Temperaturmessverfahren (500) für eine Stromversorgungsvorrichtung (100), wobei die Stromversorgungsvorrichtung (100) eine Betriebsschaltung (110), eine Schaltungsmessvorrichtung (120) und eine Rechenschaltung (130) umfasst, wobei das Temperaturmessverfahren (100) umfasst:
kontinuierliche Messung des Betriebskreises (110), um Daten (VV1, IV1, CFV1) zu erhalten, die sich über die Zeit verändern;
Bereitstellen der Daten in einem Ablenkungsmodell (DFM1), um eine simulierte Temperatur der Betriebsschaltung (110) zu erhalten, wobei das Ablenkungsmodell (DFM1) durch einen Ablenkungsvorgang gemäß einer Vielzahl von physikalischen Parametern (PQ[1]~PQ[M]) der Betriebsschaltung (110) erstellt wird; und
Bestimmung, ob der Betriebskreislauf (110) entsprechend der simulierten Temperatur anormal ist,
wobei das Ablenkungsmodell durch die folgenden Schritte erstellt wird:
Messung einer Vielzahl von ersten physikalischen Parametern (PQ[1]~PQ[M]) der Betriebsschaltung (110);
Durchführen der Ablenkungsoperation, um die ersten physikalischen Parameter in eine Vielzahl von zweiten physikalischen Parametern zu vereinfachen, wobei ein Betrag der zweiten physikalischen Parameter kleiner als ein Betrag der ersten physikalischen Parameter ist; und
Erstellung des Durchbiegungsmodells (DFM1) in Abhängigkeit von den ersten physikalischen Parametern und den zweiten physikalischen Parametern,
wobei die ersten physikalischen Parameter zumindest einen Kühlmittelfluss des Betriebskreislaufs (110), eine Kühlmitteldichte des Betriebskreislaufs (110), eine isobare spezifische Wärme des Betriebskreislaufs (110), eine Kühlmittelwärmeleitfähigkeit des Betriebskreislaufs (110) und einen Kühlmittelviskositätskoeffizienten des Betriebskreislaufs (110) umfassen, und
wobei die zweiten physikalischen Parameter eine Spannungsvariable (VV1), eine Stromvariable (IV1) und eine Kühlmitteldurchflussrate (CFV1) des Betriebskreislaufs (110) umfassen.

5. Temperaturmessverfahren (500) nach Anspruch 4, wobei das Ablenkungsmodell (DFM1) ein Matrixmodell ist und das Ablenkungsmodell so konfiguriert ist, dass es eine erste Strukturfunktion der Betriebsschaltung (110) gemäß den ersten physikalischen Parametern erzeugt.

6. Temperaturmessverfahren (500) nach Anspruch 4, wobei die Schaltungsmessvorrichtung (120) eine Temperaturmessvorrichtung (125) umfasst, und das Temperaturmessverfahren ferner umfasst:
Messen einer Anfangstemperatur (TEMO) in einem Anfangszustand der Stromversorgungsvorrichtung durch die Temperaturmessvorrichtung (125); und
Erhalt der simulierten Temperatur durch die Anfangstemperatur (TEMO), die Spannungsvariable (VV1), die Stromvariable (IV1) und den Kühlmitteldurchsatz (CFV1).

## Revendications

1. Dispositif d'alimentation électrique (100), comprenant:
un circuit de fonctionnement (110);
un dispositif de mesure du circuit (120), configuré pour détecter en continu le circuit de fonctionnement afin d'obtenir des données (VV1, IV1, CFV1) qui varient dans le temps; et
un circuit informatique (130), couplé au dispositif de mesure du circuit (120), configuré pour:
recevoir les données relatives au circuit de fonctionnement (110);
fournir les données dans un modèle de déviation (DFM1) pour obtenir une température simulée du circuit de fonctionnement (110), le modèle de déviation (DFM1) étant établi par une opération de déviation en fonction d'une pluralité de paramètres physiques (PQ[1]~PQ[M]) du circuit de fonctionnement (110); et
déterminer si le circuit de fonctionnement (110) est anormal en fonction de la température simulée,
dans lequel le modèle de déflexion (DFM1) est établi selon les étapes suivantes:
mesurer une pluralité de premiers paramètres physiques (PQ[1]~PQ[M]) du circuit de fonctionnement (110);
effectuer l'opération de déviation pour simplifier les premiers paramètres physiques en une pluralité de seconds paramètres physiques, dans laquelle une quantité de seconds paramètres physiques est inférieure à une quantité de premiers paramètres physiques; et
établir le modèle de déflexion (DFM1) en fonction des premiers paramètres physiques et des seconds paramètres physiques,
dans lequel les premiers paramètres physiques comprennent au moins un débit de liquide de refroidissement du circuit de fonctionnement (110), une densité de liquide de refroidissement du circuit de fonctionnement (110), une chaleur spécifique isobare du liquide de refroidissement du circuit de fonctionnement (110), une conductivité thermique du liquide de refroidissement du circuit de fonctionnement (110), et un coefficient de viscosité du liquide de refroidissement du circuit de fonctionnement (110), et
les seconds paramètres physiques comprennent une variable de tension (VV1), une variable de courant (IV1) et un débit de liquide de refroidissement (CFV1) du circuit de fonctionnement (110).

2. Dispositif d'alimentation électrique (100) de la revendication 1, dans lequel le modèle de déviation (DFM1) est un modèle matriciel, et le modèle de déviation (DFM1) est configuré pour générer une première fonction de structure du circuit de fonctionnement (110) en fonction des premiers paramètres physiques.

3. Dispositif d'alimentation électrique (100) de la revendication 1, dans lequel,
le dispositif de mesure du circuit (120) comprend un dispositif de mesure de la température (125), le dispositif de mesure de la température (125) étant configuré pour mesurer une température initiale (TEMO) dans un état initial du dispositif d'alimentation électrique (100); et
le circuit de calcul (130) est en outre configuré pour obtenir la température simulée par le biais de la température initiale (TEMO), de la variable de tension (VV1), de la variable de courant (IV1) et du débit du liquide de refroidissement (CFV1).

4. Procédé de mesure de la température (500) pour un dispositif d'alimentation électrique (100), le dispositif d'alimentation électrique (100) comprenant un circuit de fonctionnement (110), un dispositif de mesure de circuit (120) et un circuit de calcul (130), la méthode de mesure de la température (100) comprenant:
détecter en continu le circuit de fonctionnement (110) pour obtenir une donnée (VV1, IV1, CFV1) qui varie dans le temps;
fournir les données dans un modèle de déviation (DFM1) pour obtenir une température simulée du circuit de fonctionnement (110), le modèle de déviation (DFM1) étant établi par une opération de déviation en fonction d'une pluralité de paramètres physiques (PQ[1]~PQ[M]) du circuit de fonctionnement (110); et
déterminer si le circuit de fonctionnement (110) est anormal en fonction de la température simulée,
dans lequel le modèle de déflexion est établi selon les étapes suivantes:
mesurer une pluralité de premiers paramètres physiques (PQ[1]~PQ[M]) du circuit de fonctionnement (110);
effectuer l'opération de déviation pour simplifier les premiers paramètres physiques en une pluralité de seconds paramètres physiques, dans laquelle une quantité de seconds paramètres physiques est inférieure à une quantité de premiers paramètres physiques; et
établir le modèle de déflexion (DFM1) en fonction des premiers paramètres physiques et des seconds paramètres physiques,
dans lequel les premiers paramètres physiques comprennent au moins un débit de liquide de refroidissement du circuit de fonctionnement (110), une densité de liquide de refroidissement du circuit de fonctionnement (110), une chaleur spécifique isobare du liquide de refroidissement du circuit de fonctionnement (110), une conductivité thermique du liquide de refroidissement du circuit de fonctionnement (110), et un coefficient de viscosité du liquide de refroidissement du circuit de fonctionnement (110), et
les seconds paramètres physiques comprennent une variable de tension (VV1), une variable de courant (IV1) et un débit de liquide de refroidissement (CFV1) du circuit de fonctionnement (110).

5. Procédé de mesure de la température (500) de la revendication 4, dans lequel le modèle de déviation (DFM1) est un modèle matriciel, et le modèle de déviation est configuré pour générer une première fonction de structure du circuit de fonctionnement (110) en fonction des premiers paramètres physiques.

6. Procédé de mesure de la température (500) de la revendication 4, dans lequel le dispositif de mesure du circuit (120) comprend un dispositif de mesure de la température (125), et la méthode de mesure de la température comprend en outre:
mesure d'une température initiale (TEMO) dans un état initial du dispositif d'alimentation électrique par le dispositif de mesure de la température (125); et
obtenir la température simulée à partir de la température initiale (TEM0), de la variable de tension (VV1), de la variable de courant (IV1) et du débit du liquide de refroidissement (CFV1).
